Europäisches Patentamt

European Patent Office

Office européen des brevets

(19)

(11) Publication number: **0 170 134**
**B1**

# (12) EUROPEAN PATENT SPECIFICATION

(45) Date of publication of the patent specification:
08.02.89

(51) Int. Cl.⁴: **H03K 19/094, H03K 19/017**

(21) Application number: **85108714.8**

(22) Date of filing: **12.07.85**

(54) Schottky diode field effect transistor logic circuit.

(30) Priority: **19.07.84 US 632359**

(43) Date of publication of application:
**05.02.86 Bulletin 86/6**

(45) Publication of the grant of the patent:
**08.02.89 Bulletin 89/6**

(84) Designated Contracting States:
**DE FR GB**

(56) References cited:
EP-A- 0 075 915
DD-A- 40 592
US-A- 4 300 064

PATENT ABSTRACTS OF JAPAN, vol. 7,
no. 154 (E-185)[1299], 6th July 1983; & JP - A
- 58 62939 (HITACHI SEISAKUSHO K.K.) 14-04-1983

IEEE ELECTRON DEVICE LETTERS, vol. EDL-3, no. 9,
September 1982, pages 264-267; New York, US; M.R.
NAMORDI et al.: "A novel low-power static GaAs
MESFET logic gate",
PATENT ABSTRACTS OF JAPAN, vol. 7,
no. 17 (E-154)[1162], 22nd January 1983; & JP - A
- 57 176 837 (HITACHI SEISAKUSHO K.K.) 30-10-1982

(73) Proprietor: HONEYWELL INC., Honeywell Plaza,
Minneapolis Minnesota 55408(US)

(72) Inventor: **Tho, T. Vu, 7661 Brigadoon Place, Fridley
Minnesota 55432(US)**

(74) Representative: **Rentzsch, Heinz et al, Honeywell
Europe S.A. Holding KG Patent- und Lizenzabteilung
Kaiserleistrasse 55, D-6050 Offenbach am Main(DE)**

(56) References cited: (continuation)
IEEE JOURNAL OF SOLID-STATE CIRCUITS, vol. SC-19,
no. 1, February 1984, pages 10-22; New York, US; T.T. VU
et al.: "A gallium arsenide SDFL gate array with on-chip
RAM"

## Description

This invention relates to integrated logic curcuits wherein diodes serve as the nonlinear logic elements and field effect transistors (FETs) are switched in response to current flowing through the diodes. The invention particularly relates to such logic circuits herein the substrate is a solid with high electron mobility such as gallium arsenide (GaAs), or indium phosphide (InP) and the diodes are Schottky diodes.

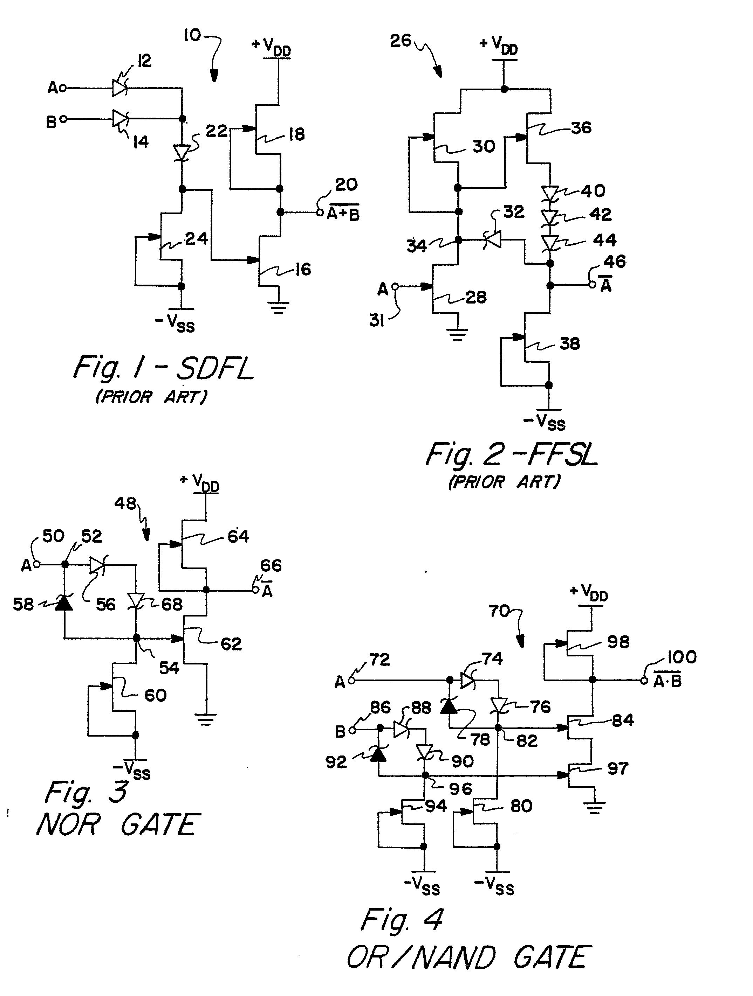

A logic circuit according to the precharacterizing portion of claim 1 is known from US–A 4 300 064 which discloses a new logic family commonly referred to as Schottky diode field effect transistor logic (SDFL). The basic SDFL NOR logic circuit is shown in Figure 1. Schottky diode logic elements 12 and 14 are rendered conductive or nonconductive depending on logic inputs signals A and B. If at least one of diodes 12 or 14 are conducting, FET 16 is turned on which allows current to flow through an electrical load (e.g., pull up FET 18) and thereby affect the logic condition of the output 20. Voltage level shifting diodes, such as diode 22, are employed to allow the use of switching FETs with higher pinch-off voltages. FET 24 serves as a current source for biasing Schottky diodes 12, 14 and 22. Depletion mode MESFETs are preferably employed due to the limits of present processing technology. With a GaAs substrate, SDFL provides a very fast logic circuit.

Another GaAs MESFET logic gate is discussed in "A Low Power, Static GaAs MESFET Logic Gate", M.R. Namordi and W.A. White, GaAs IC Symposium, pages 21-24, IEEE 1982, and is referred to as a feed-forward static logic (FFSL) gate. FFSL is a combination of two other logic circuits referred to as buffered FET logic (BFL) and capacitive coupled logic (CCL).

The basic FFSL gate 26 is shown in Figure 2. FFSL uses a FET 28 as the nonlinear logic element, and FET 28 in conjunction with an electrical load (e.g., pull up FET 30) serves to invert logic signals input at node 31. FFSL features a "feed-forward capacitor" (i.e., the depletion capacitance of reverse biased Schottky diode 32) connected between an inverting logic node 34 and a voltage shifter/driver circuit branch (i.e., FETs 36 and 38 and Schottky diodes 40, 42 and 44). High frequency signals are transmitted to the voltage shifter branch through the depletion capacitance of reverse biased diode 32, allowing for very fast switching of the next stage which is coupled to output 46. The use of a feed-forward capacitor enhances design flexibility by allowing the gate width of the voltage shifting branch to be reduced relative to the gate width of a comparable voltage shifting branch in BFL without degrading speed performance. By reducing the gate width of the voltage shifting branch, power dissipation can be reduced.

The above prior art logic circuits still have disadvantages. The use of a GaAs substrate in SDFL allows for fast switching. However, the switching speed of SDFL is limited by the charging and discharging of the gate capacitance of switching FET 16. FFSL uses a FET as a nonlinear logic element. FETs require considerable chip area due to their relatively large size and, being a three terminal device, additional area to accommodate overcrossings necessitated by the three terminals.

It is the object of the present invention to provide a logic circuit which can operate faster than SDFL (or conversely at the same speed yet dissipate less power), but which can retain the high density provided by SDFL due to the use of Schottky diodes as the nonlinear logic elements. This object is achieved by the invention as characterized in claim 1. Improvements and preferred embodiments thereof are described in the subclaims.

The invention is an integrated logic circuit having a logic input, a logic output and a solid substrate. Schottky diodes integral with the substrate are connected such that they pass substantial current only in opposite directions along separate circuit branches between first and second nodes. The logic input is electrically connected to the first node and the logic signal at the second node is inverted to generate the logic output. A means for reverse biasing the diodes of one of the branches and for forward biasing the diodes of the other branch is provided. The above indicated signal inversion is preferably accomplished by switching a depletion mode MESFET with a logic signal from the second node. The substrate is perferably a material with high electron mobility such as GaAs or InP.

A plurality of Schottky diodes can be included in each circuit branch as long as all diodes in a single branch are adapted to pass substantial current only in the same direction.

The basic circuit employing the invention is used as a building block to construct multiple input logic circuits.

## BRIEF DESCRIPTION OF THE DRAWINGS

Figure 1 is a schematic of a prior art SDFL circuit.
Figure 2 is a schematic of a prior art FFSL gate.
Figure 3 is a schematic of a NOR gate employing the present invention.
Figure 4 is a schematic of an OR/NAND gate employing the present invention.
Figure 5 is a schematic of a high fan-out NOR gate employing the present invention.
Figure 6 is a schematic of a NOR gate employing the present invention and including an enhancement FET.

## DESCRIPTION OF PREFERRED EMBODIMENTS

As used herein "direct electrical connection" or "directly electrically connected" means connected by way of a low resistance conductive path without other circuit components such as FET junctions, diodes, capacitors or inductors therebetween. "Electrically connected" or "electrical connection", on the other hand, includes the direct connections defined above but also includes coupling through other circuit components such as those described above.

The present invention is shown in Figure 3. Therein circuit 48 has a logic input 50, nodes 52 and 54 respectively, first Schottky diode 56, second Schottky diode 58, current source means (e.g., depletion mode, source-gate shorted MESFET 60), a switching transistor (preferably a depletion mode MESFET 62), an electrical load or drain current source (preferably source-gate shorted, depletion mode MESFET 64) and logic output 66.

Logic input 50 and node 52 are directly electrically connected, therefore a direct electrical connection to node 52 is also a direct electrical connection to logic input 50. Functionally, node 52 can serve as the logic input.

Schottky diode 56 has its anode directly electrically connected to node 52 and its cathode electrically connected (either directly or through an optional voltage level shifting means such as Schottky diode 68) to node 54. Schottky diode 58 has its cathode electrically connected to node 52 and its anode electrically connected to node 54. Diodes 56 and 58 are adapted to pass substantial current only in opposite directions between nodes 52 and 54. MESFET 60 has its drain connected to node 54. MESFET 60 in conjunction with negative voltage supply $-V_{SS}$ serve to bias Schottky diodes 56, 58 and 68. MESFET 62 has its gate electrically connected to node 54, its source grounded and the logic output is taken at its drain. Pull up FET 64 is connected between the drain of MESFET 62 and positive voltage supply $+V_{DD}$.

In operation, circuit 48 receives a digital logic input signal A at logic input 50. Schottky diodes 56 and 68 are always forward biased and Schottky diode 58 (a feed-reverse capacitor-diode) is always reverse biased. However, when A is high (e.g., logic 1), the forward bias voltage on Schottky diodes 56 and 68 is such that the current flowing through these diodes in the forward direction is relatively large causing a significant voltage drop across MESFET 60. This raises the voltage at node 54, and thus output node 66 is pulled low resulting in a low (i.e., O) logic signal. If A is low (i.e., logic O), the current flowing through Schottky diodes 56 and 68 is relatively low. Thus the voltage at node 54 is low and output node 66 is pulled high resulting in a high (i.e. 1) logic signal. FETS 62 and 64 serve to invert the voltage signal at node 54 by switching FET 62 on if node 54 is high and switching FET 62 off if node 54 is low.

The advantage of the present invention over SDFL circuit 10 of Figure 1 is twofold. First, when FET 62 is switched off, its gate capacitance is discharged through the depletion capacitance of reverse biased Schottky diode 58 and through a similar switching FET (not shown) of a previous stage. (Note that if FET 62 is off, a similar switching FET of a previous stage will be on due to the inverting function performed by circuit 48). This discharge path is in addition to another discharge path provided in both SDFL circuit 10 and circuit 48, i.e., a discharge path through pull down FET 60 (FET 60 is always on). This additional discharge path allows for faster discharge of the gate capacitance of FET 62 than if Schottky diode 58 were not present. This in turn means that FET 62 (and thus circuit 48) will switch faster than SDFL circuit 10.

The second advantage of the present invention over SDFL is also due to the depletion capacitance of reverse biased Schottky diode 58. When FET 62 is on, the depletion capacitance of Schottky diode 58 charges to some extent. For high speed switching, some portion of the charge accumulated on the capacitance of reverse biased Schottky diode 58 during the time when FET 62 is on will still be present when FET 62 is next switched on. This residual charge in effect precharges node 54 so that less of a voltage change is needed to switch FET 62 on than if Schottky diode 58 were not utilized.

SPICE computer program simulation results for circuit 48 are shown in table 1 below for two different loading conditions (i.e., $C_L$ (capacitance of the gates being driven) = 23fF and $C_L$=350fF). The large value of $C_L$ represents a long wire loading and high fan-out condition. Table 2 shows the input parameters used to generate the data of table 1. This simulation simulated the very low power operation of circuit 48. The speed advantage of the feed-reverse capacitor-diode will increase for higher power gates.

EP 0 170 134 B1

Table 1. Simulation results

W/O: Without feed reverse capacitive diode
W.F.R.C.D.: With feed reverse capacitive diode

| Symbol | Description | $C_L = 23$ fF | | $C_L = 350$ fF | | Unit |
|---|---|---|---|---|---|---|
| | | W/O | WFRCD | W/O | WFRCD | |
| DL | logic diode-56 | 1×3 | 1×3 | 1×3 | 1×3 | $\mu m^2$ |
| DS | level shifting diode-68 | 2×3 | 2×3 | 2×3 | 2×3 | $\mu m^2$ |
| FRCD | feed reverse diode-58 | No | 6×6 | No | 6×6 | $\mu m^2$ |
| PU | pull-up TR-64 | 2×3 | 2×3 | 2×3 | 2×3 | $\mu m^2$ |
| Q | switching TR-62 | 1×12 | 1×12 | 1×12 | 1×12 | $\mu m^2$ |
| PD | pull-down TR-60 | 16×3 | 16×3 | 16×3 | 16×3 | $\mu m^2$ |
| P | power/gate | 123 | 123 | 123 | 123 | $\mu W$ |
| $t_{on}$ | turn-on time | 0.900 | 0.786 | 1.724 | 1.681 | ns |
| $t_{off}$ | turn-off time | 0.714 | 0.614 | 1.724 | 1.638 | ns |
| $t_{avr}$ | delay per gate | 0.807 | 0.700 | 1.724 | 1.666 | ns |
| $V_{DD}$ | power supply | | 1.0 | | 1.0 | volt |
| $V_{SS}$ | power supply | | −1.5 | | −1.5 | volt |

Table 2. Input Parameters for Diodes and Transistors

| | Diode | | | Transistor | | | Unit |
|---|---|---|---|---|---|---|---|
| | DL-56 | DS-68 | FRCD-58 | PU-64 | Q-62 | PD-60 | |
| | (1×3) | (2×3) | (6×6) | 2×3 | 1×12 | 16×3 | $\mu m^2$ |
| $V_j$ | 0.66 | 0.68 | 0.70 | — | — | — | Volt |
| $R_s$ | 371 | 155 | 50 | — | — | — | ohm |
| $C_{jo}$ | 2.49 | 4.98 | 30.0 | — | — | — | fF |
| $I_s$ | 14.2 | 13.0 | 78.0 | — | — | — | pAmp. |
| N | 1.52 | 1.42 | 1.42 | — | — | — | — |
| PB | | | | 0.76 | 0.76 | 0.76 | Volt |
| $C_{gso}$ | — | — | — | 12.2 | 26.46 | 39.0 | fF |
| $C_{gdo}$ | — | — | — | 12.2 | 26.46 | 39.0 | fF |
| BETA | — | — | — | 0.76 | 0.62 | 0.015 | $mA/V^2$ |
| $R_s (R_d)$ | — | — | — | 60 | 60 | 12 | ohm |
| $V_{TO}$ | — | — | — | −0.9 | −0.9 | −0.9 | Volt |
| LAMBDA | — | — | — | 0.08 | 0.08 | 0.08 | — |
| $I_s$ | — | — | — | 5.1 | 10.2 | 16.0 | pAmp. |

Parameter Description:

$V_j$ — Junction Potential
$R_s$ — Diode Resistance
$C_{jo}$ — Junction Capacitance
$I_s$ — Saturation Current
N — Nonideal Factor
PB — Barrier Height
$C_{gso}$ — Gate Source Capacitance
$C_{gdo}$ — Gate-Drain Capacitance
BETA — Constant
$R_s (R_d)$ — Source (Drain) Resistance
$V_{TO}$ — Threshold Voltage
LAMBDA — Constant

4

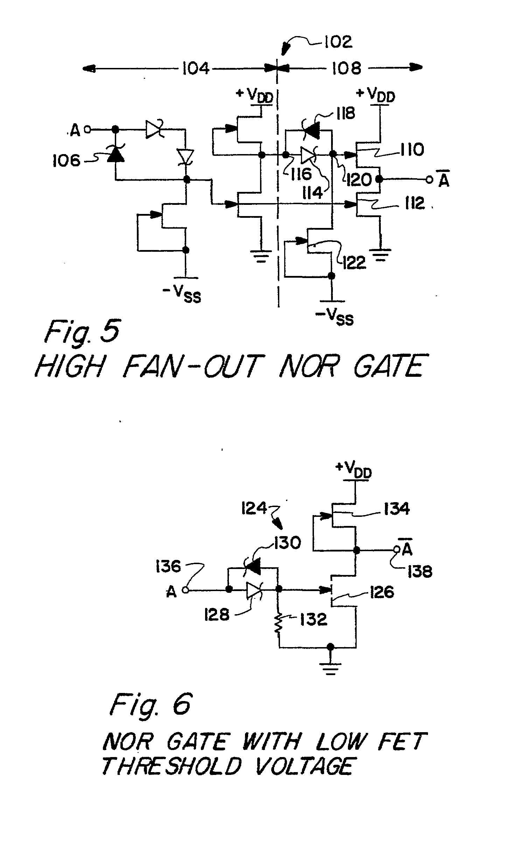

Figure 4 shows an OR/NAND gate 70 with two inputs A and B employing the present invention. In Figure 4, as in Figures 3 and 5, feed-reverse capacitor-diodes are darkened. The first logic input 72 leads to Schottky diodes 74, 76 and 78 which are configured like the Schottky diodes in circuit 48 with FET 80 serving as the bias current source. The logic signal at node 82 switches FET 84. Second logic input 86 leads to Schottky diodes 88, 90 and 92, which again are configured like the Schottky diodes in circuit 48, with FET 94 serving as the bias current source. The logic signal at node 96 switches FET 97. FETs 84 and 97 are connected in series with the drain of FET 97 connected to the source of FET 84. The source of FET 97 is connected to ground. The drain of FET 84 is in turn connected in series with the source of pull up FET 98. The drain of pull up FET 98 is connected to the positive voltage supply +$V_{DD}$.

The AND function is performed on the inputs to the gates of FETS 84 and 97, and the combination of FETs 84, 97 and 98 invert the AND result. The net result of circuit 70 is to perform an OR/NAND operation. Additional inputs, each leading to a set of Schottky diodes, and additional FETs in series with FETs 84 and 97 can be used to increase the fan-in of circuit 70.

Figure 5 displays a NOR gate 102 for high fan-out which employs the present invention. Circuit 102 is comprised of two portions. The first portion 104 is the basic NOR gate of Figure 3. The feed-reverse capacitor-diode in portion 104 is shown as diode 106. The second portion 108 increases the drive capability of portion 104 by feeding complement and true logic signals to the gates of FETs 110 and 112, respectively. FETs 110 and 112 are thus driven in complementary fashion and provide additional power as compared to circuit 48 of Figure 3.

Schottky diode 114 is provided to lower the voltage level of node 116 (i.e., the logic output of portion 104) to accommodate the negative threshold voltage of depletion mode MESFET 110. A second feed-reverse capacitor-diode 118 is employed in circuit 102 to increase the switching speed of FET 110. Schottky diode 118 is electrically connected between nodes 116 and 120. FET 122 supplies bias current for diode 114.

The present invention is shown utilizing solely depletion mode MESFETS. It could also be implemented with an enhancement mode MESFET. In Figure 6, circuit 124 includes enhancement mode switching FET 126, nonlinear logic element Schottky diode 128, feed-reverse capacitor diode 130, a current bias source (e.g., resistor 132), pull up FET/load 134, input 136 and output 138. The threshold voltage of FET 126 is preferrably centered around O volts (e.g., −0.2v to 0.2v). This approach will result in a logic circuit which is more tolerant to threshold voltage variations than conventional enhancement direct coupled FET logic (DCFL).

Additional diodes can be added to either circuit branch between nodes 52 and 54 in Figure 3. For example, a forward biased diode (not shown) could be added in series with diodes 56 and 68 to further shift the voltage level of a logic signal. Although additional reverse biased diodes (not shown) could be added in series with diode 58, generally only one reverse biased diode will be used. The feed-reverse capacitance can be increased by simply using a larger reverse biased diode.

For high frequency operation, circuit 48 of Figure 3 is advantageously configured with the depletion capacitance of Schottky diode 58 being three or four times larger than the total capacitance of the gates being driven. This is because the depletion capacitance of Schottky diode 58 and the load capacitance acts as a divider network.

As a corollary to the speed advantage of the present invention, speed could be maintained at the level of SDFL with the current source and positive voltage supplies being reduced, thus reducing the power dissipated by the present invention as compared to SDFL.

The present invention is preferably an integrated circuit having a solid substrate (not shown) with high electron mobility such as GaAs or InP. Other semiconductor substrates, such as silicon, could of course also be used. MESFETS and Schottky diodes are the preferable circuit components since they are easily fabricated on GaAs.

A further advantage of the present invention over SDFL is an extension of the range of frequency response. The basic SDFL circuit has a low pass filter response with an upper cut-off frequency. Inclusion of the feed-reverse capacitor-diode will increase the upper cut off frequency as compared to SDFL for equal loading of wire interconnect and fan-out. Also, for the same switching speed, power dissipation with SDFL employing a feed-reverse capacitor diode will be reduced as compared to SDFL without such a diode.

## Claims

1. A logic circuit comprising:
a) a solid substrate;
b) a logic input (50, 72, 136);
c) a logic output (66, 100, 138);
d) a voltage reference point (ground) and being adapted to connect to a first voltage supply ($V_{DD}$);
e) a first Schottky diode (56, 74, 128) integral with said substrate and having a first anode and a first cathode, wherein said first anode is directly electrically connected to said logic input (50, 72, 136), said first cathode is comprised of metal and said first cathode is electrically connected to a first node (54, 82);

f) current source means (60, 80, 132) electrically connected to said first node;

g) a first transistor integral (62, 84, 126) with said substrate and having a first source region, a first drain region and a first control region, wherein said first control region is electrically connected to said first node (54, 82), said first source region is electrically connected to said reference point ground, and said first drain region is electrically connected to said logic output (66, 100, 138);

h) an electrical load means (64, 98, 134) integral with said substrate, wherein said electrical load means is electrically connected to and between said first drain region and said first voltage supply (VDD);

characterized by

i) a second Schottky diode (58) integral with said substrate and having a second anode and a second cathode, wherein said second cathode is comprised of metal and is directly electrically connected to said logic input, and wherein said second anode is electrically connected to said first node (54, 82).

2. The circuit of claim 1, characterized by: a third Schottky diode (68, 76) having a third anode and a third cathode, wherein said third anode is directly electrically connected to said first cathode and said third cathode is electrically connected to said first node (54, 82) (Fig. 3, 4).

3. The circuit of claim 1, characterized by:

j) a third Schottky diode (114) integral with said substrate and having a third cathode and a third anode, wherein said third cathode is comprised of metal, and wherein said third anode is directly electrically connected to said logic output (66 or 116) and said third cathode is directly electrically connected to a second node (120);

k) a fourth Schottky diode (118) integral with said substrate and having a fourth anode and a fourth cathode, wherein said fourth cathode is comprised of metal, and wherein said fourth anode is directly electrically connected to said second node (120) and said fourth cathode is directly electrically connected to said logic output (66 or 116) (Fig. 5).

4. The circuit of claim 1 or 3, characterized by:

l) a first circuit branch between said logic output and a second node (120), said first circuit branch including at least a third Schottky diode (114), said third Schottky diode being adapted to pass substantial current only from said logic output (116 or 66) to said second node (120); and

m) a second circuit branch being said second node and said logic output including at least a fourth Schottky diode (118), said fourth Schottky diode being adapted to pass substantial current only from said second node (120) to said logic output (116).

5. The circuit of claim 1 or 3, characterized in that said current source means includes a second transistor (60, 80; 122) having a second source region, a second drain region and a second control region, and wherein said second source region is directly electrically connected to said second control region, said second source region is directly electrically connected to a second voltage supply (−VSS) and said second drain region is directly electrically connected to said first node (54, 82, 120).

6. The circuit of claim 5, characterized in that said electrical load means includes a third transistor (64, 98, 134) having a third source region, a third drain region and a third control region, wherein said third source region is directly electrically connected to said third control region and to said first drain region, and said third drain region is directly electrically connected to said first voltage supply (VDD).

7. The circuit according to one of the preceding claims, characterized by:

n) a first circuit branch (56, 68; 74, 76) between said logic input and a first node (54, 82), said first circuit branch including a first set of Schottky diodes, said first set of Schottky diodes having at least one Schottky diode (56, 74), wherein each of said diodes in said first set have an anode and a cathode, wherein the cathodes of said first set of diodes are each comprised of metal, said first set of diodes being connected in series along said first circuit branch such that substantial current can pass only along said first branch from said logic input (50, 72) to said first node (54, 82);

o) a second circuit branch (58, 78) between said first node (54, 82) and said logic input (50, 72), said second circuit branch including a second set of Schottky diodes, said second set including at least one diode (58, 78), wherein each of said second sets of diodes has a cathode and an anode, wherein the cathodes of said second set of diodes are each comprised of metal, and wherein the diodes of said second set are connected in series along said second circuit branch such that substantial current can pass only along said second current branch from said first node to said logic input.

8. The circuit of claim 7, characterized by:

p) a third circuit branch between said logic output (66 or 116) and a second node (120), said third circuit branch including at least one Schottky diode (114) adapted to pass substantial current only from said logic output (66 or 116) to said second node (120); and

q) a fourth circuit branch (118) between said second node (120) and said logic output (66 or 116), said fourth circuit branch including at least one Schottky diode (118) adapted to pass substantial current only from said second node (120) to said logic output (116 or 66).

9. The circuit of claim 1, characterized by:

r) a first circuit branch between said first logic input (86) and a first node (96), said first circuit branch including at least one Schottky diode (88) adapted to pass substantial current only from said first logic input (86) to said first node (96);

s) a second circuit branch from said first node (96) to said first logic input (86), said second circuit branch including at least one Schottky diode (92) adapted to pass substantial current only from said first node (96) to said first logic input (86);

t) a first current source means (94) for biasing said Schottky diodes in said first and said second current branches;

u) a third circuit branch between said second logic input (72) and a second node (82), said third circuit vranch including at least one Schottky diode (74) adapted to pass substantial current only from said second logic input (72) to said second node (82);

v) a fourth circuit branch between said second node (82) and said second logic input (72), said fourth circuit branch including at least one Schottky diode (78) adapted to pass substantial current only from said second node (82) to said second logic input (72);

w) second current source means (80) for biasing said Schottky diodes in said third and said fourth circuit branches;

x) a first field effect transistor (FET) (97) having a first source, a first drain and a first control region, wherein said first control region is electrically connected to said first node (96) and said first source region is electrically connected to said voltage reference point (ground);

y) a second field effect transistor (FET) (84) having a second control region, a second source region and a second drain region, wherein said second control region is electrically connected to said second node (82) and said second source region is electrically connected to said first drain region; and

z) a drain current means (98) electrically connected to said voltage supply (V$_{DD}$) and to said logic output (100), said drain current means being adapted to supply current to said first (84) and second (97) FETs (Fig. 4).

10. The circuit of claim 9, characterized in that said drain current means (98) is a third field effect transistor (98) having a third control region, a third source region and a third drain region, and wherein said third drain region is directly electrically connected to said voltage supply (V$_{DD}$) and said third source region is directly electrically connected to said second drain region and to said third control region.

11. The circuit of one of the preceding claims, characterized in that the substrate is selected from the group consisting of gallium arsenide (GaAs) and indium phosphide (InP).

12. The circuit of one of the preceding claims, characterized in that said first transistor is a depletion mode metal-semiconductor field effect transistor (MESFET).

13. The circuit of claim 12, characterized in that said second (60) and third transistors (64) are depletion mode metal-semiconductor field effect transistors (MESFETS).

14. The circuit according to one of the claims 1 to 11, characterized in that said first transistor is an enhancement mode metal-semiconductor field effect transistor (126) (MESFET), and said current source means includes a resistor (132) (Fig. 6).

**Patentansprüche**

1. Logischer Schaltkreis mit

a) einem Festkörpersubstrat;

b) einem logischen Eingang (50, 72, 136);

c) einem logischen Ausgang (66, 100, 138);

d) einem Spannungsbezugspunkt (Masse) und einem Anschluß an eine erste Versorgungsspannung (V$_{DD}$);

e) einer in das Substrat integrierten ersten Schottky-Diode (56, 74, 128) mit einer ersten Anode und einer ersten Kathode, wobei die erste Anode unmittelbar elektrisch an den logischen Eingang (50, 72, 136) angeschlossen ist, die erste Kathode aus Metall besteht und elektrisch an einen ersten Knotenpunkt (54, 82) angeschlossen ist;

f) einer an den ersten Knotenpunkt angeschlossenen Stromquelle (60, 80, 132);

g) einem in das Substrat integrierten ersten Transistor (62, 84, 186) mit einer ersten Quellen-Region, einer ersten Senken-Region und einer ersten Steuer-Region, wobei die erste Steuer-Region elektrisch an den ersten Knotenpunkt (54, 82) angeschlossen ist, die erste Quellen-Region elektrisch am Spannungsbezugspunkt liegt und die erste Senken-Region elektrisch an den logischen Ausgang (66, 100, 138) geführt ist;

h) einer in das Substrat integrierten elektrischen Last (64, 98, 134), die zwischen die erste Senken-Region und die erste Versorgungsspannung (V$_{DD}$) angeschlossen ist;

gekennzeichnet durch

i) eine zweite in das Substrat integrierte Schottky-Diode (58) mit einer zweiten Anode und einer zweiten Kathode, wobei die zweite Kathode aus Metall besteht und elektrisch direkt an den logischen Eingang angeschlossen ist, während die zweite Anode elektrisch mit dem ersten Knotenpunkt (54, 82) in Verbindung steht.

2. Schaltkreis nach Anspruch 1, gekennzeichnet durch eine dritte Schottky-Diode (68, 76) mit einer dritten Anode und einer dritten Kathode, wobei die dritte Anode elektrisch direkt an die erste Kathode und die dritte Kathode elektrisch direkt an den ersten Knotenpunkt (54, 82) angeschlossen ist (Fig. 3, 4).

3. Schaltkreis nach Anspruch 1, gekennzeichnet durch j) eine in das Substrat integrierte dritte Schottky-Diode (114) mit einer dritten Kathode und einer dritten Anode, wobei die dritte Kathode aus Metall besteht und die dritte Anode elektrisch direkt an den logischen Ausgang (66 oder 166) angeschlossen ist, während die dritte Kathode elektrisch direkt an einen Knotenpunkt (120) geführt ist;

k) eine in das Substrat integrierte vierte Schottky-Diode (118) mit einer vierten Anode und einer vierten Kathode, wobei die vierte Kathode aus Metall besteht und die vierte Anode elektrisch direkt an den zweiten Knotenpunkt (120) angeschlossen ist, während die vierte Kathode elektrisch direkt mit dem logischen Ausgang (66 oder 116) in Verbindung steht (Fig. 5).

4. Schaltkreis nach Anspruch 1 oder 3, gekennzeichnet durch

l) eine erste Stromkreisverzweigung zwischen dem logischen Ausgang und dem zweiten Knotenpunkt (120), wobei diese logische Verzweigung wenigstens eine dritte Schottky-Diode (114) enthält, welche einen wesentlichen Strom nur vom logischen Ausgang (116 oder 66) zum zweiten Knotenpunkt (120) leitet; und

m) eine zweite Stromkreisverzweigung zwischen dem zweiten Knotenpunkt und dem logischen Ausgang, die wenigstens eine vierte Schottky-Diode (188) umfaßt, welche einen wesentlichen Strom nur vom zweiten Knotenpunkt (120) zum logischen Ausgang (116) leitet.

5. Schaltkreis nach Anspruch 1 oder 3, dadurch gekennzeichnet, daß die Stromquelle einen zweiten Transistor (60, 80; 122) mit einer zweiten Quellen-Region, einer zweiten Senken-Region und einer zweiten Steuer-Region umfaßt und wobei die zweite Quellen-Region elektrisch direkt an die zweite Steuer-Region angeschlossen ist, die zweite Quellen-Region elektrisch direkt an eine zweite Versorgungsspannung (−V$_{SS}$) geführt ist und die zweite Senken-Region elektrisch direkt mit dem ersten Knotenpunkt (54, 82, 120) in Verbindung steht.

6. Schaltkreis nach Anspruch 5, dadurch gekennzeichnet, daß die elektrische Last einen dritten Transistor (64, 98, 134) mit einer dritten Quellen-Region, einer dritten Senken-Region und einer dritten Steuer-Region umfaßt, wobei die dritte Quellen-Region elektrisch direkt an die dritte Steuer-Region und die erste Senken-Region angeschlossen ist und die dritte Senken-Region elektrisch direkt mit der ersten Versorgungsspannung (V$_{DD}$) in Verbindung steht.

7. Schaltkreis nach einem der vorangehenden Ansprüche, gekennzeichnet durch

n) eine erste Stromkreisverzweigung (56, 68, 74, 76) zwischen dem logischen Eingang und einem ersten Knotenpunkt (54, 82), die eine erste Gruppe von Schottky-Dioden enthält, welche ihrerseits wenigstens eine Schottky-Diode (56, 74) umfaßt, wobei jede der Dioden in der ersten Gruppe eine Anode und eine Kathode aufweist und wobei die Kathoden der Dioden der ersten Gruppe jeweils aus Metall bestehen und die erste Gruppe von Dioden derart mit der ersten Stromkreisverzweigung in Reihe geschaltet sind, daß ein wesentlicher Strom nur längs dieser ersten Verzweigung vom logischen Eingang (50, 72) zum ersten Knotenpunkt (54, 82) fließen kann;

o) eine zweite Stromkreisverzweigung (58, 78) zwischen dem ersten Knotenpunkt (54, 82) und dem logischen Eingang (50, 72), die eine zweite Gruppe von Schottky-Dioden umfaßt, welche wenigstens eine Diode (54, 78) enthält, wobei jede Diode der zweiten Gruppe eine Kathode und eine Anode hat und die Kathoden der zweiten Gruppe jeweils aus Metall bestehen und wobei die Dioden der zweiten Gruppe mit der zweiten Stromkreisverzweigung derart in Reihe geschaltet sind, daß ein wesentlicher Strom nur längs dieser zweiten Stromkreisverzweigung vom ersten Knotenpunkt zum logischen Ausgang fließen kann.

8. Stromkreis nach Anspruch 7, gekennzeichnet durch

p) eine dritte Stromkreisverzweigung zwischen dem logischen Ausgang (66 oder 116) und einem zweiten Knotenpunkt (120), die wenigstens eine Schottky-Diode (114) enthält, welche einen wesentlichen Strom nur vom logischen Ausgang (66 oder 116) zum zweiten Knotenpunkt (120) leitet; und

q) eine vierte Stromkreisverzweigung (118) zwischen dem zweiten Knotenpunkt (120) und dem logischen Ausgang (66 oder 116), die wenigstens eine Schottky-Diode (118) umfaßt und einen wesentlichen Strom nur vom zweiten Knotenpunkt (120) zum logischen Ausgang (116 oder 66) fließen läßt.

9. Schaltkreis nach Anspruch 1, gekennzeichnet durch

r) eine erste Stromkreisverzweigung zwischen dem ersten logischen Eingang (86) und einem Knotenpunkt (96), die wenigstens eine Schottky-Diode (88) umfaßt, welche einen wesentlichen Strom nur vom ersten logischen Eingang (86) zum ersten Knotenpunkt (96) fließen läßt;

s) eine zweite Stromkreisverzweigung vom ersten Knotenpunkt (96) zum ersten logischen Eingang (86), die wenigstens eine Schottky-Diode (92) enthält, welche einen wesentlichen Strom nur vom ersten Knotenpunkt (96) zum ersten logischen Eingang (86) leitet;

t) eine erste Stromquelle (94) zum Vorspannen der Schottky-Dioden in den ersten und zweiten Stromkreisverzweigungen;

u) eine dritte Stromkreisverzweigung zwischen dem zweiten logischen Eingang (72) und einem zweiten Knotenpunkt (82), die wenigstens eine Schottky-Diode (64) umfaßt und einen wesentlichen Strom nur vom zweiten logischen Eingang (72) zum zweiten Knotenpunkt (82) fließen läßt;

v) eine vierte Stromkreisverzweigung zwischen dem zweiten Knotenpunkt (82) und dem zweiten logischen Eingang (72), die wenigstens eine Schottky-Diode (78) enthält, welche einen wesentlichen Strom nur vom zweiten Knotenpukt (82) zum zweiten logischen Eingang (72) fließen läßt;

w) eine zweite Stromquelle (80) zum Vorspannen der Schottky-Dioden in der dritten und vierten Stromkreisverzweigung;

x) einen ersten Feldeffekttransistor (FET) (97) mit einer ersten Quellen-, einer ersten Senken- und einer ersten Steuer-Region, wobei die erste Steuer-Region elektrisch an den ersten Knotenpunkt (96) und die erste Quellen-Region elektrisch an den Bezugsspannungspunkt angeschlossen ist;

y) einen zweiten Feldeffekttransistor (FET) (84) mit einer zweiten Steuer-, einer zweiten Quellen- und einer zweiten Senken-Region, wobei die zweite Steuer-Region elektrisch an den zweiten Knotenpunkt (82) und die zweite Quellen-Region elektrisch an die erste Senken-Region angeschlossen ist; und z) eine Stromsenke (98), die elektrisch an die Versorgungsspannung ($V_{DD}$) und an den logischen Ausgang (100) angeschlossen ist, wobei die Stromsenke Stom zum ersten (84) und zum zweiten (97) Feldeffekttransistor leitet (Fig. 4).

10. Schaltkreis nach Anspruch 9, dadurch gekennzeichnet, daß die Stromsenke (98) ein dritter Feldeffekttransistor (98) mit einer dritten Steuer-Region, einer dritten Quellen-Region und einer dritten Senken-Region ist und wobei die dritte Senken-Region elektrisch direkt an die Versorgungspannung ($V_{DD}$) und die dritte Quellen-Region elektrisch direkt an die zweite Quellen-Region und die dritte Steuer-Region angeschlossen sind.

11. Schaltkreis nach einem der vorangehenden Ansprüche, dadurch gekennzeichnet, daß das Substrat aus Galiumarsenid (GaAs) oder Indiumphosphid (InP) besteht.

12. Schaltkreis nach einem der vorangehenden Ansprüche, dadurch gekennzeichnet, daß der erste Transistor ein Depletion-Mode-Metall-Halbleiterfeldeffekttransistor (MESFET) ist.

13. Schalterkreis nach Anspruch 12, dadurch gekennzeichnet, daß der zweite (60) und der dritte Transistor (64) Depletion-Mode-Metall-Halbleiterfeldeffekttransistoren (MESFETs) sind.

14. Schaltkreis nach einem der Ansprüche 1 bis 11, dadurch gekennzeichnet, daß der erste Transistor (126) ein Enhancement-Mode-Metall-Halbleiterfeldeffekttransistor (MESFET) ist und die Stromquelle einen Widerstand (132) enthält (Fig. 6).

**Revendications**

1. Circuit logique comprenant:

a) un substrat solide;

b) une entrée logique (50, 72, 136);

c) une sortie logique (66, 100, 138);

d) un point de référence en tension (masse) adapté à être connecté à une première alimentation en tension ($V_{DD}$);

e) une première diode Schottky (56, 74, 128) formée dans le substrat et comprenant une première anode et une première cathode, dans laquelle la première anode est connectée électriquement directement à l'entrée logique (50, 72, 136), la première cathode est composée de métal et est connectée électriquement à un premier nœud (54, 82);

f) des moyens de source de courant (60, 80, 132) connectés électriquement au premier nœud;

g) un premier transistor (62, 84, 126) formé dans le substrat et comprenant une première région de source, une première région de drain et une première région de commande, dans lequel la première région de commande est connectée électriquement au premier nœud (54, 82), la première région de source est connectée électriquement au point de référence à la masse, et la première région de drain est connectée électriquement à la sortie logique (66, 100, 138);

h) un moyen de charge électrique (64, 98, 134) formé dans le substrat, dans lequel le moyen de charge électrique est connecté électriquement à et entre la première région de drain et la première alimentation en tension ($V_{DD}$);

caractérisé par

i) une seconde diode Schottky (58) formée dans le substrat et comprenant une seconde anode et une seconde cathode, dans laquelle la seconde cathode est composée de métal et est connectée électriquement directement à l'entrée logique, et dans laquelle la seconde anode est connectée électriquement au premier nœud (54, 82).

2. Circuit selon la revendication 1, caractérisé par une troisième diode Schottky (68, 76) comprenant une troisième anode et une troisième cathode, dans laquelle la troisième anode est connectée électriquement directement à la première cathode et la troisième cathode est connectée électriquement au premier nœud (54, 82) (figures 3, 4).

3. Circuit selon la revendication 1, caractérisé par:

j) une troisième diode Schottky (114) formée dans le substrat et comprenant une troisième cathode et une troisième anode, dans laquelle la troisième cathode est composée de métal, et dans laquelle la troisième anode est connectée électriquement directement à la sortie logique (66 ou 116) et la troisième cathode est connectée électriquement directement à un second nœud (120);

k) une quatrième diode Schottky (118) formée dans le substrat et comprenant une quatrième anode et une quatrième cathode, dans laquelle la quatrième cathode est composée de métal, et dans laquelle la quatrième anode est connectée électriquement directement au second nœud (120) et la quatrième cathode est connectée électriquement directement à la sortie logique (66 ou 116) (figure 5).

4. Circuit selon la revendication 1 ou 3, caractérisé par:

l) une première branche de circuit entre la sortie logique et un second nœud (120), la première branche de circuit comprenant au moins une troisième diode Schottky (114), la troisième diode Schottky étant adaptée pour laisser passer un courant substantiel seulement de la sortie logique (116 ou 66) au second nœud (120); et

m) une seconde branche de circuit entre le second nœud et la sortie logique comprenant au moins une quatrième diode Schottky (118), la quatrième diode Schottky étant adaptée pour laisser passer un courant substantiel seulement du second nœud (120) à la sortie logique (116).

5. Circuit selon la revendication 1 ou 3, caractérisé en ce que le moyen de source de courant comprend un second transistor (60, 80; 122) comprenant une seconde région de source, une seconde région de drain et une seconde région de commande, et dans lequel la seconde région de source est connectée électriquement directement à la seconde région de commande, la seconde région de source est connectée électriquement directement à une seconde alimentation en tension (−V$_{SS}$) et la seconde région de drain est connectée électriquement directement au premier nœud (54, 82, 120).

6. Circuit selon la revendication 5, caractérisé en ce que le moyen de charge électrique comprend un troisième transistor (64, 98, 134) comprenant une troisième région de source, une troisième région de drain et une troisième région de commande, dans lequel la troisième région de source est connectée électriquement directement à la troisième région de commande et à la première région de drain, et la troisième région de drain est connectée électriquement directement à la première alimentation en tension (V$_{DD}$).

7. Circuit selon l'une quelconque des revendications précédentes, caractérisé par:

n) une première branche de circuit (56, 68; 74, 76) entre l'entrée logique et un premier nœud (54, 82), la première branche de circuit comprenant un premier ensemble de diodes Schottky, ce premier ensemble de diodes Schottky comprenant au moins une diode Schottky (56, 74), dans laquelle chacune des diodes du premier ensemble comprend une anode et une cathode, dans laquelle les cathodes du premier ensemble de diodes sont chacune composée de métal, le premier ensemble de diodes étant connectée en série le long de la première branche de circuit de telle façon qu'un courant substantiel peut passer seulement le long de la première branche de l'entrée logique (50, 72) au premier nœud (54, 82);

o) une seconde branche de circuit (58, 78) entre le premier nœud (54, 82) et l'entrée logique (50, 72), la seconde branche de circuit comprenant un second ensemble de diodes Schottky, ce second ensemble comprenant au moins une diode (58, 78), dans laquelle chacun des seconds ensembles de diodes comprend une cathode et une anode, dans laquelle les cathodes du second ensemble de diodes sont chacune composées de métal, et dans laquelle les diodes du second ensemble sont connectées en série le long de la seconde branche de circuit de telle façon qu'un courant substantiel peut passer seulement le long de la seconde branche de courant du premier nœud à l'entrée logique.

8. Circuit selon la revendication 7, caractérisé par:

p) une troisième branche de circuit entre la sortie logique (66 ou 116) et un second nœud (120), la troisième branche de circuit comprenant au moins une diode Schottky (114) adaptée pour laisser passer un courant substantiel seulement de la sortie logique (66 ou 116) ou second nœud (129); et

q) une quatrième branche de circuit (118) entre le second nœud (129) et la sortie logique (66 ou 116), la quatrième branche de circuit comprenant au moins une diode Schottky (118) adaptée pour laisser passer un courant substantiel seulement du second nœud (120) à la sortie logique (116 ou 66).

9. Circuit selon la revendication 1, caractérisé par:

r) une première branche de circuit entre la première entrée logique (86) et un premier nœud (96), la première branche de circuit comprenant au moins une diode de Schottky (88) adaptée pour laisser passer un courant substantiel seulement de la première entrée logique (86) au premier nœud (96);

s) une seconde branche de circuit du premier nœud (96) à la première entrée logique (86), la seconde branche de circuit comprenant au moins une diode Schottky (92) adaptée pour laisser passer un courant substantiel seulement du premier nœud (96) à la première entrée logique (86);

t) un premier moyen de source de courant (94) pour polariser les diodes Schottky dans les première et seconde branches de courant;

u) une troisième branche de circuit entre la seconde entrée logique (72) et un second nœud (82), la troisième branche de circuit comprenant au moins une diode Schottky (74) adaptée pour laisser passer un courant substantiel seulement de la seconde entrée logique (72) au second nœud (82);

v) une quatrième branche de circuit entre le second nœud (82) et la seconde entrée logique (72), la quatrième branche de circuit comprenant au moins une diode Schottky (78) adaptée pour laisser passer un courant substantiel seulement du second nœud (82) à la seconde entrée logique (72);

w) un second moyen de source de courant (80) pour polariser les diodes Schottky dans les troisième et quatrième branches de circuit;

x) un premier transistor à effet de champ (FET) (97) comprenant une première source, un premier drain et une première région de commande, dans lequel la première région de commande est connectée électriquement au premier nœud (96) et la première région de source est connectée électriquement au point de référence en tension (masse);

y) un second transistor à effet de champ (FET) (84) comprenant une seconde région de commande, une seconde région de source et une seconde région de drain, dans lequel la seconde région de commande est connectée électriquement au second nœud (82) et la seconde région de source est connec-

teé électriquement à la première région de drain; et

z) un moyen de courant de drain (98) connecté électriquement à l'alimentation en tension ($V_{DD}$) et à la sortie logique (100), le moyen de courant de drain étant adapté pour fournir un courant aux premier (4) et second (97) FET (figure 4).

10. Circuit selon la revendication 9, caractérisé en ce que le moyen de courant de drain (98) est un troisième transistor à effet de champ (98) comprenant une troisième région de commande, une troisième région de source et une troisième région de drain, et dans lequel la troisième région de drain est connectée électriquement directement à l'alimentation en tension ($V_{DD}$) et la troisième région de source est connectée électriquement directement à la seconde région de drain et à la troisième région de commande.

11. Circuit selon l'une quelconque des revendications précédentes, caractérisé en ce que le substrat est sélectionneé à partir du groupe constitué par l'arséniure de gallium (GaAs) et le phosphure d'indium (InP).

12. Circuit selon l'une quelconque des revendications précédentes, caractérisé en ce que le premier transistor est un transistor à effet de champ métal-semiconducteur (MESFET) en mode déplété.

13. Circuit selon la revendication 12, caractérisé en ce que les second (60) et troisième transistors (64) sont des transistors à effet de champ métal-semiconducteur (MESFET) en mode déplété.

14. Circuit selon l'une quelconque des revendications 1 à 11, caractérisé en ce que le premier transistor est un transistor à effet de champ métal-semiconducteur (MESFET) en mode enrichi (126), et le moyen de source de courant comprend une résistance (132) (figure 6).

EP 0 170 134 B1

Fig. 1 – SDFL
(PRIOR ART)

Fig. 2 – FFSL
(PRIOR ART)

Fig. 3
NOR GATE

Fig. 4
OR/NAND GATE

EP 0 170 134 B1

Fig. 5
HIGH FAN-OUT NOR GATE

Fig. 6
NOR GATE WITH LOW FET
THRESHOLD VOLTAGE